# EUROPÄISCHE PATENTSCHRIFT

(11) **EP 0 330 122 B1**
(45) Veröffentlichungstag und Bekanntmachung des Hinweises auf die Patenterteilung: **25.10.1995**
(21) Anmeldenummer: 89102916.7
(22) Anmeldetag: 20.02.1989
(51) Int. Cl.: H01L 29/72, H01L 29/08, H01L 29/43, H01L 21/328

(54) **Verfahren zur Herstellung eines durch Feldeffekt steuerbaren Bipolartransistors**
Method of manufacturing a field-effect-controllable bipolar transistor
Méthode de formation d'un transistor bipolaire commandable par effet de champ

(30) Priorität: 24.02.1988 DE 3805799
(43) Veröffentlichungstag der Anmeldung: 30.08.1989
(73) Patentinhaber: SIEMENS AKTIENGESELLSCHAFT, 80333 München (DE)
(72) Erfinder: Miller, Gerhard, Dr., D-8916 Penzing (DE); Strack, Helmut, Dr., D-8000 München 40 (DE); Tihanyi, Jenö, Dr., D-8000 München 70 (DE)

(56) Entgegenhaltungen:
- EP-A- 0 148 065
- GB-A- 2 088 631
- IEEE TRANSACTIONS ON ELECTRON DEVICES, Band ED-33; Nr. 9, September 1986,Seiten 1377-1382, IEEE, New York, US; J.G. FOSSUM et al.: "Charge-controlanalysis of the COMFET turn-off transient"
- S.M. Sze: VLSI Technology; 1983, McGraw-Hill; S. 228-229.

## Beschreibung

Die Erfindung bezieht sich auf ein Verfahren zum Herstellen eines durch Feldeffekt steuerbaren Bipolartransistors mit einem Halbleiterkörper mit einer Innenzone und einer an die Innenzone angrenzenden drainseitigen Zone höherer Dotierung als die Innenzone und vom entgegengesetzten Leitungstyp.

Ein solcher Bipolartransistor ist z.B. Gegenstand der gemäß Artikel 54 (3) zu berücksichtigenden EP 0 313 000 A1. Der in diesem Dokument enthaltene, durch Feldeffekt steuerbare Bipolartransistor ist sourceseitig wie ein Leistungs-MOSFET aufgebaut, hat jedoch anodenseitig eine vierte Zone, die den entgegengesetzten Leitungstyp wie die Innenzone aufweist. Er hat somit eine Thyristorstruktur. Am Stromtransport sind hier wie beim Thyristor, aber im Gegensatz zum Leistungs-MOSFET, beide Arten von Ladungsträgern beteiligt. Das bringt einerseits den Vorteil eines niedrigen Durchlaßwiderstandes, andererseits aber den Nachteil einer Sperrverzögerungsladung, die sich beim Abschalten in einem sogenannten "Tail-Strom" bemerkbar macht. Dieser verzögert das Abschalten.

Im genannten Dokument wurde vorgeschlagen, die Sperrverzögerungsladung dadurch abzusenken, daß die drainseitige Zone durch die rekristallisierte Zone eines Gold-Silizium-Eutektikums gebildet ist. Dabei kann die drainseitige Zone sehr dünn gemacht werden, z.B 1/10 µm. Zur Herstellung der rekristallisierten Zone werden in die anodenseitige Oberfläche Ionen mit einer Dosis 5 x 10¹⁴ cm⁻² implantiert. Dann wird Gold abgeschieden und anschließend wird ein Gold-Silizium-Eutektikum erzeugt, das Borionen enthält. Nach dem Abkühlen des Eutektikums rekristallisiert angrenzend an die Innenzone die drainseitige Zone aus, die Borionen enthält. Welche Dotierung diese drainseitige Zone hat, läßt sich dem Dokument nicht entnehmen.

Ziel der Erfindung ist es, ein Verfahren zum Herstellen eines durch Feldeffekt steuerbaren Bipolartransistors der oben genannten Gattung anzugeben, mit dem die Speicherladung auf andere Weise verringert werden kann.

Dieses Ziel wird durch die Merkmale erreicht:
a) Die drainseitige Zone wird weniger als 1 µm dick gemacht,
b) die drainseitige Zone wird mit einer Dosis zwischen 1 x 10¹² und 1 x 10¹⁵ cm⁻² dotiert,
c) die Lebensdauer der Minoritätsladungsträger in der Innenzone wird mindestens auf 10 µs eingestellt.

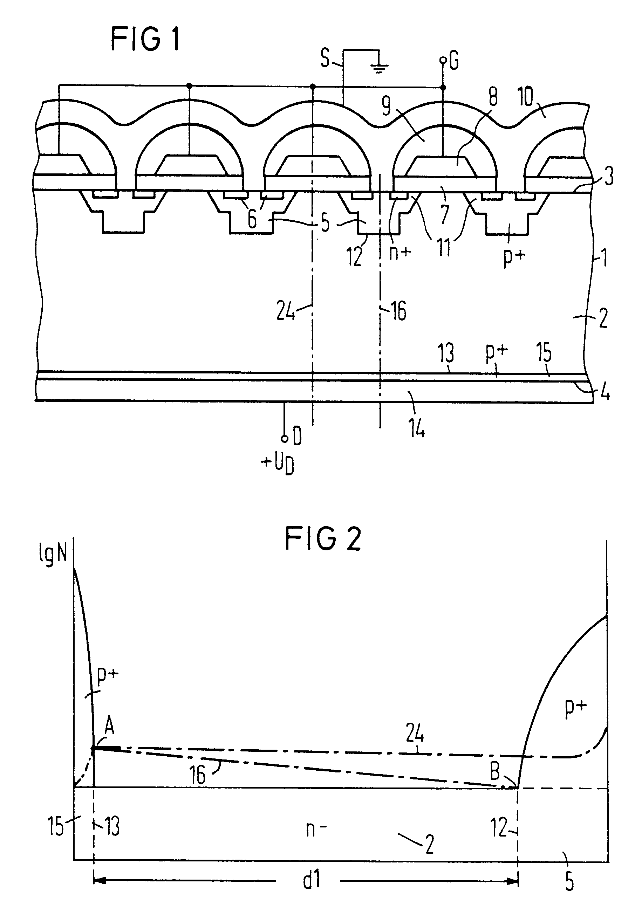

Weiterbildungen der Erfindung sind Gegenstand der Unteransprüche. Die Erfindung wird anhand von Ausführungsbeispielen in Verbindung mit den Figuren 1 und 5 näher erläutert. Es zeigen:
- Figur 1: einen Schnitt durch einen IGBT,
- Figur 2: die Dotierung und die Ladungsträgerverteilung im stromführenden Zustand,
- Figur 3 und 4: zwei verschiedene Ausführungsbeispiele der Kontaktierung der drainseitigen Zone,
- Figur 5: den Verlauf des Stroms und der Spannung beim Abschalten.

Der durch Feldeffekt steuerbare Bipolartransistor nach Figur 1, im folgenden IGBT (Isolated Gate Bipolar Transistor) genannt, hat einen Halbleiterkörper 1 mit einer n-dotierten Innenzone 2. Die Dotierung liegt z.B. bei 1-2 x 10¹⁴ cm⁻³. Der Halbleiterkörper hat eine sourceseitige Oberfläche 3 und eine drainseitige Oberfläche 4. Die Innenzone 2 reicht bis an die sourceseitige Oberfläche 3. Angrenzend an diese Oberfläche sind in die Innenzone 2 Basiszonen 5 eingebettet, die stark p-dotiert sind. Sie bilden mit der Innenzone pn-Übergänge 12. In jede Basiszone 5 ist eine stark n-dotierte Sourcezone 6 eingebettet. Ihre Dotierung ist höher als die der Basiszonen 5. Auf der Oberfläche 3 sitzt eine Isolierschicht 7, auf der einander parallel geschaltete Gateelektroden 8 angeordnet sind. Die Gateelektroden 8 überdecken einen an die Oberfläche 3 tretenden Teil der Basiszonen 5 und bilden dort Kanalzonen 11. Die Gateelektroden 8 sind von einer weiteren Isolierschicht 9 bedeckt. In den Isolierschichten 7 und 9 sind Öffnungen vorgesehen, durch die die Sourcezonen 6 und die Basiszonen 5 von einer auf der Isolierschicht 9 liegenden Sourceelektrode 10 kontaktiert sind. Diese besteht vorzugsweise aus Aluminium. Die gemeinsame Kontaktierung der Zonen 5 und 6 durch den Sourcekontakt 10 stellt einen starken Nebenschluß dar.

Drainseitig schließt sich an die Innenzone 2 eine p-Schicht 15 an. Sie ist wesentlich höher dotiert als die Innenzone 2. Zwischen der drainseitigen Zone 15 und der Innenzone 2 liegt ein pn-Übergang 13. Die Zone 15 ist mit einer Drainelektrode 14 kontaktiert.

Die drainseitige Zone hat eine Dicke von kleiner 1µm, vorzugsweise 0,1 µm. Sie wird auf bekannte Weise z. B. durch eine Bor-Ionenimplantation mit einer Dosis zwischen 1 x 10¹² und 1 x 10¹⁵, vorzugsweise zwischen 1 x 10¹³ und 1 x 10¹⁴cm⁻² und einer Energie von 45 keV hergestellt. Werden andere Ionen implantiert, so wird die Energie derart eingestellt, daß sich die oben erwähnte Eindringtiefe ergibt. Das Silizium des Halbleiterkörpers ist derart beschaffen, daß sich in der Innenzone 2 eine Lebensdauer der aus den Zonen 5 und 15 stammenden Minoritätsladungsträger von mindestens 10µs ergibt. Diese Bedingung ist im allgemeinen ohne weiteres bereits dadurch zu erfüllen, daß der Halbleiterkörper von einem herkömmlichen Zonen- oder tiegelgezogenen Silizium-Monokristallstab abgetrennt und bei seiner Weiterverarbeitung nicht zusätzlich mit Rekombinationszentren bildenden Stoffen dotiert wird. Die genannte Lebensdauer ist z. B. für einen für 1000 V Sperrspannung ausgelegten IGBT mit einer Innenzonendicke von z. B. 200µm so groß, daß in der Innenzone nur eine verschwindend geringe Rekombination von Ladungsträgern stattfindet. Die Lebensdauer kann aber auch wesentlich höher liegen, z. B. in der Größenordnung 100µs. 10µs reicht aber bei 200 µm Dicke aus, da die Laufzeit nur bei etwa 2µs liegt.

Das Schaubild in FIG 2 zeigt ausgezogen den Dotierungsverlauf und strichpunktiert die Konzentration der freien Ladungsträger im Durchlaßfall. Die Dotierung in der Innenzone 2 ist konstant und durch die Grunddotierung des Halbleitermaterials gegeben.

Die Zone 15 hat eine um mehrere Zehnerpotenzen höhere Randkonzentration, ebenso jede Basiszone 5. Während die Basiszone 5 z. B. durch Ionenimplantation und anschließendes Eindiffundieren erzeugt werden kann, wird die Zone 15 lediglich durch Implantieren von Ionen ohne nachfolgende Eindiffusion hergestellt. Es wird danach lediglich eine Temperaturbehandlung unter 600 ° C durchgeführt, bei der der Dotierstoff noch nicht wesentlich in den Halbleiterkörper eindiffundiert. Anstelle der Temperaturbehandlung unter 600°C kann auch das RTA (Rapid Temperature Annealing) mittels Laser- oder Lichtblitz angewendet werden. Mit beiden Verfahren wird nur ein Teil der durch die Ionenimplantation erzeugten Kristallgitterschäden ausgeheilt. Dies führt zusammen mit der äußerst geringen Dicke der Zone 15 zu einer sehr geringen Emitter-Gummelzahl (Quotient aus Emitterladung und Emitter-Diffusionskonstante) und dadurch zu einem geringen Emitterwirkungsgrad der Zone 15. Damit ist die Anhebung der Minoritätsladungsträger über die Grunddotierung in der Innenzone 2 relativ gering (Punkt A). Da die Innenzone 2 jedoch sehr wenig, d. h. keine zusätzlichen Rekombinationszentren aufweist, fällt die Dichte der freien Ladungsträger (p=n in FIG. 2) über die Dicke der Innenzone 2 im wesentlichen linear bis zur Dichte Null am sourceseitigen pn-Übergang 12, der stets gesperrt ist (Linie 16 in FIG 1). Die Konzentration der freien Ladungsträger in einem Schnitt unterhalb der Gateelektroden (Linie 24 in FIG 1) unterscheidet sich im Durchlaßfall dadurch, daß die Konzentration der freien Ladungsträger p=n sourceseitig angehoben ist.

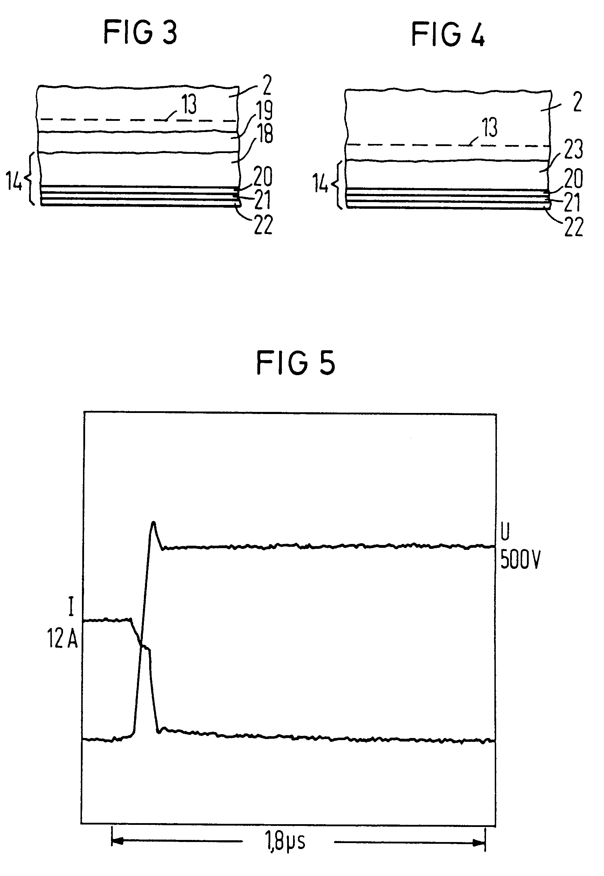

Die Zone 15 wird durch einen Drainkontakt 14 kontaktiert, dessen Aufbau in Verbindung mit FIG 3 und 4 beschrieben wird. So kann der Kontakt beispielsweise durch Aufsputtern einer Aluminiumschicht 18 hergestellt werden, die teilweise in den Halbleiterkörper 2 einlegiert wird. Dabei bildet sich eine Aluminium-Silizium-Legierung 19, die bei entsprechender Prozeßführung nicht bis zum pn-Übergang 13 vordringt. Dies kann z. B. durch Erhitzen auf 450°C für 30 Minuten erreicht werden. Die Aluminiumschicht 18 kann dann auf bekannte Weise mit einem Mehrschichtenkontakt versehen, der beispielsweise aus einer Titanschicht 20, einer Nickelschicht 21 und einer Silberschicht 22 besteht.

Der Kontakt 14 kann (FIG 4) auch über ein Metall-Silizid mit dem Halbleiterkörper verbunden werden. Hierzu wird z. B. eine Schicht Platin auf die Oberfläche 4 des Halbleiterkörpers aufgebracht, dann wird durch Tempern eine Platin-Silizidschicht 23 gebildet. Hier läßt sich der Prozeß durch Aufsputtern einer entsprechend dünnen Platinschicht so steuern, daß nach Temperaturbehandlung bei 450 bis 470 ° C für ca. 1 h , die Platin-Silizidschicht 23 nicht bis an den pn-Übergang 13 heranreicht. Die Platin-Silizid-Schicht 23 kann dann ähnlich wie in FIG 3 durch einen Mehrschichtenkontakt 20, 21, 22 kontaktiert werden.

In FIG 5 ist der Abschaltstrom I und die Spannung U gegen die Abschaltzeit t bei einem IGBT der Erfindung dargestellt. Es ist ersichtlich, daß die Verlustarbeit sehr klein ist. Im gezeigten Beispiel beträgt sie ca. 0,68 mWs.
Die Erfindung wurde anhand eines n-Kanal-IGBT beschrieben. Sie kann selbstverständlich auch für p-Kanal-IGBT eingesetzt werden, bei dem statt einer p⁺-Zone 15 eine n⁺-Zone verwendet wird. Diese kann z. B. durch Implantation von Phosphorionen hergestellt werden. Anschließend kann wieder ein mehrschichtiger Kontakt aufgebracht werden, der z.B. aus Platinsilizid, Titan, Nickel, Silber besteht.

## Patentansprüche

1. Verfahren zum Herstellen eines durch Feldeffekt steuerbaren Bipolartransistors mit einem Halbleiterkörper (1) mit einer Innenzone (2) und einer an die Innenzone (2) angrenzenden drainseitigen Zone (15) höherer Dotierung als die Innenzone (2) und vom entgegengesetzten Leitungstyp, mit den Merkmalen:
a) Die drainseitige Zone (15) wird weniger als 1 µm dick gemacht,
b) die drainseitige Zone (15) wird mit einer Dosis zwischen 1 x 10¹² und 1 x 10¹⁵ cm⁻² dotiert,
c) die Lebensdauer der Minoritätsladungsträger in der Innenzone (2) wird mindestens auf 10 µs eingestellt.

2. Verfahren nach Anspruch 1,
**dadurch gekennzeichnet**, daß die drainseitige Zone (15) durch eine Metallschicht (18) kontaktiert wird, und daß die Metallschicht (18) mit dem Halbleiterkörper (1) durch Legieren verbunden wird.

3. Verfahren nach Anspruch 2,
**dadurch gekennzeichnet,** daß die Metallschicht (18) aus Aluminium besteht.

4. Verfahren nach Anspruch 1,
**dadurch gekennzeichnet,** daß die drainseitige Zone (15) durch eine Metallschicht kontaktiert wird und daß die Metallschicht mit dem Halbleiterkörper (1) über eine Metall-Silizidschicht (23) verbunden wird.

5. Verfahren nach Anspruch 4,
**dadurch gekennzeichnet,** daß die Metallschicht aus einem der Metalle Platin, Titan, Wolfram, Molybdän besteht.

6. Verfahren zum Herstellen eines durch Feldeffekt steuerbaren Bipolartransistors nach Anspruch 1,
**dadurch gekennzeichnet,** daß die durch die Implantation verursachten Gitterschäden in der drainseitigen Zone (15) bei einer Temperatur von unter 600 °C ausgeheilt werden.

7. Verfahren zum Herstellen eines durch Feldeffekt steuerbaren Bipolartransistors nach Anspruch 1,
**dadurch gekennzeichnet**, daß die durch die Implantation verursachten Gitterschäden in der drainseitigen Zone (15) durch "Rapid Thermal Annealing" ausgeheilt werden.

## Claims

1. Method for producing a field-effect-controllable bipolar transistor having a semiconductor body (1) which has an inner region (2) and, adjoining the inner region (2), a drain-side region (15) having a higher doping than the inner region (2) and of the opposite conduction type, having the features:
a) the drain-side region (15) is made to be less than 1 µm thick,
b) the drain-side region (15) is doped with a dose of between 1 × 10¹² and 1 × 10¹⁵ cm⁻²,
c) the life of the minority charge carriers in the inner region (2) is adjusted to at least 10 µs.

2. Method according to Claim 1, characterized in that the drain-side region (15) is made contact with by a metal layer (18), and in that the metal layer (18) is connected to the semiconductor body (1) by alloying.

3. Method according to Claim 2, characterized in that the metal layer (18) is composed of aluminium.

4. Method according to Claim 1, characterized in that the drain-side region (15) is made contact with by a metal layer, and in that the metal layer is connected to the semiconductor body (1) via a metal silicide layer (23).

5. Method according to Claim 4, characterized in that the metal layer is composed of one of the metals platinum, titanium, tungsten and molybdenum.

6. Method for producing a field-effect-controllable bipolar transistor according to Claim 1, characterized in that the lattice damage, caused by the implantation, in the drain-side region (15) is annealed at a temperature of below 600°C.

7. Method for producing a field-effect-controllable bipolar transistor according to Claim 1, characterized in that the lattice damage, caused by the implantation, in the drain-side region (15) is annealed by rapid thermal annealing.

## Revendications

1. Procédé pour fabriquer un transistor bipolaire commandable par effet de champ, comportant un corps semiconducteur (1) possédant une zone intérieure (2) et une zone (15) située du côté du drain et qui jouxte la zone intérieure (2), possède un dopage supérieur à celui de la zone intérieure (2) et possède un type de conductivité opposé, présentant les caractéristiques suivantes :
a) on règle l'épaisseur de la zone (15), située du côté du drain, à une épaisseur inférieure à 1 mm,
b) on dope la zone (15), située du côté du drain, avec une dose comprise entre 1 x 10¹² et 1 x 10¹⁵ cm⁻²,
c) on règle la durée de vie des porteurs de charges minoritaires dans la zone intérieure (2) à au moins 10 ms.

2. Procédé suivant la revendication 1, caractérisé par le fait qu'on place une couche métallique (18) en contact avec la zone (15) située du côté du drain et qu'on relie par alliage la couche métallique (18) au corps semiconducteur (1) .

3. Procédé suivant la revendication 2, caractérisé par le fait que la couche métallique (18) est formée d'aluminium.

4. Procédé suivant la revendication 1, caractérisé en ce qu'on place une couche métallique en contact avec la zone (15) située du côté du drain et qu'on relie la couche métallique au corps semiconducteur (1) par l'intermédiaire d'une couche de siliciure métallique (23).

5. Procédé suivant la revendication 4, caractérisé par le fait que la couche métallique est formée de l'un des métaux platine, titane, tungstène, molybdène.

6. Procédé pour fabriquer un transistor bipolaire commandable par effet de champ suivant la revendication 1, caractérisé par le fait qu'on applique un recuit à une température inférieure à 600°C aux défauts du réseau, provoqués par l'implantation, dans la zone (15) située du côté du drain.

7. Procédé pour fabriquer un transistor bipolaire commandable par effet de champ suivant la revendication 1, caractérisé par le fait qu'on applique un recuit "Rapid Thermal Annealing" aux défauts du réseau, provoqués par l'implantation, dans la zone (15) située du côté du drain.
